# EUROPEAN PATENT APPLICATION

(11) **EP 4 401 118 A2**
(43) Date of publication of application: **17.07.2024**
(21) Application number: 24150981.9
(22) Date of filing: 09.01.2024
(51) Int. Cl.: H01L 21/67

(54) **METHOD OF TRANSFERRING MICRO SEMICONDUCTOR CHIP AND TRANSFERRING STRUCTURE**

(30) Priority: 10.01.2023 KR 20230003511
(71) Applicant: Samsung Electronics Co., Ltd., Suwon-si, Gyeonggi-do 16677 (KR)
(72) Inventor: OH, Youngtek, 16678 Suwon-si (KR); PARK, Joonyong, 16678 Suwon-si (KR); HWANG, Kyungwook, 16678 Suwon-si (KR); KIM, Dongkyun, 16678 Suwon-si (KR); KIM, Dongho, 16678 Suwon-si (KR); SONG, Sanghoon, 16678 Suwon-si (KR); YU, Minchul, 16678 Suwon-si (KR); HWANG, Junsik, 16678 Suwon-si (KR)
(74) Representative: Elkington and Fife LLP

(57) **Abstract**

Provided are a method of transferring a micro semiconductor chip and a transferring structure, wherein the method includes providing a plurality of base transferring substrates each including a plurality of grooves, aligning the plurality of base transferring substrates on a first bottom substrate, aligning the plurality of base transferring substrates on a second bottom substrate, providing a target transferring structure by transferring micro semiconductor chips to the base transferring substrates of the first bottom substrate, and providing a preliminary transferring structure by transferring micro semiconductor chips to the base transferring substrates of the second bottom substrate.

## Description

### FIELD OF THE INVENTION

The disclosure relates to a method of transferring a micro semiconductor chip by using a base transferring substrate, and a transferring structure.

### BACKGROUND OF THE INVENTION

Liquid crystal displays (LCDs), organic light emitting diode (OLED) displays, and similar technologies like have been widely used as display devices. Recently, a technology for manufacturing high-resolution display devices by using micro semiconductor chips has been spotlighted.

Display devices using micro semiconductor chips require many technologies, such as a transfer technology for moving micro-sized light emitting devices to desired display pixel positions, repair processes, and methods of implementing desired colors.

### SUMMARY OF THE INVENTION

One or more embodiments provide a method of transferring a micro semiconductor chip by using a base transferring substrate.

Further, one or more embodiments provide a transferring structure including a base transferring substrate. The transferring structure may refer to a source wafer or substrate which supplies micro semiconductor chips to a target wafer or substrate.

According to an aspect of the disclosure, a method of transferring a micro semiconductor chip includes providing a plurality of base transferring substrates each including a plurality of grooves, aligning the plurality of base transferring substrates on a first bottom substrate, aligning the plurality of base transferring substrates on a second bottom substrate, providing a target transferring structure by transferring micro semiconductor chips to the base transferring substrates of the first bottom substrate, providing a preliminary transferring structure by transferring micro semiconductor chips to the base transferring substrates of the second bottom substrate, and replacing an error base transferring structure on which micro semiconductor chips are not transferred, from among base transferring structures of the target transferring structure, with a normal base transferring structure on which micro semiconductor chips are transferred, from among base transferring structures of the preliminary target transferring structure.

The transferring of the micro semiconductor chips may be performed by a wet transfer method or a dry transfer method.

The base transferring substrate may include a substrate and a mold provided on the substrate, and the grooves may be provided in the mold.

The base transferring substrate may include a transferring mold, and a protrusion pattern may provided on an upper surface of the transferring mold.

Each of the plurality of base transferring substrates may include N × M grooves, wherein N and M are natural numbers in a range of 2 to 1,000.

The method may further include bonding the micro semiconductor chips, which are transferred to the plurality of base transferring substrates of the target transferring structure, to a display substrate.

According to an aspect of the disclosure, a method of transferring a micro semiconductor chip may include: providing a plurality of base transferring substrates comprising a plurality of grooves; providing a plurality of preliminary transferring substrates by aligning the plurality of base transferring substrates on a plurality of bottom substrates; forming a preliminary transferring structure by transferring micro semiconductor chips to the plurality of preliminary transferring substrates; and aligning, on a bottom substrate of a target transferring structure, a normal base transferring structure to which micro semiconductor chips are transferred, from among base transferring structures of the plurality of preliminary transferring substrates.

The transferring of the micro semiconductor chips is performed by a wet transfer method or a dry transfer method.

The base transferring substrate may include a substrate and a mold provided on the substrate, and the grooves may be provided in the mold.

The base transferring substrate may include a transferring mold, and a protrusion pattern may provided on an upper surface of the transferring mold.

Each of the plurality of base transferring substrates comprises N × M grooves, wherein N and M are natural numbers in a range of 2 to 1,000.

According to another aspect of the disclosure, a method of transferring a micro semiconductor chip, may include: providing a transferring mold substrate comprising a plurality of grooves; transferring micro semiconductor chips to the transferring mold substrate; forming base transferring structures by segmenting the transferring mold substrate to which the micro semiconductor chips are transferred; and aligning, on a bottom substrate of a target transferring structure, a normal base transferring structure to which the micro semiconductor chips are transferred, from among the base transferring structures.

The transferring of the micro semiconductor chips is performed by a wet transfer method or a dry transfer method.

The base transferring substrate may include a substrate and a mold provided on the substrate, and the grooves may be provided in the mold.

The base transferring substrate may include a transferring mold, and a protrusion pattern may provided on an upper surface of the transferring mold.

The base transferring structures may include N × M grooves, wherein N and M are natural numbers in a range of 2 to 1,000.

The method may further include: inspecting the base transferring structures to identify an error base transferring structure in which the micro semiconductor chips are not transferred, and the normal base transferring structure to which the micro semiconductor chips are transferred.

The method may further include: replacing the error base transferring structure with the normal base transferring structure on which the micro semiconductor chips are transferred.

According to another aspect of the disclosure, a micro semiconductor chip transferring structure includes a bottom substrate, and a plurality of base transferring substrates arranged on the bottom substrate, wherein each of the base transferring substrates includes a transferring mold including a plurality of grooves and micro semiconductor chips accommodated in the grooves.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1A illustrates a base transferring substrate used in a method of transferring a micro semiconductor chip, according to an embodiment;
FIG. 1B illustrates a bottom substrate used in a method of transferring a micro semiconductor chip, according to an embodiment;
FIG. 1C illustrates a micro semiconductor chip transferring substrate according to an embodiment;
FIGS. 1D to 1G illustrate various examples of a cross-sectional view taken along line A-A' of FIG. 1C;
FIG. 1H is a view illustrating a method of transferring a micro semiconductor chip, according to an embodiment;
FIG. 1I is a view illustrating a method of replacing a base transferring structure by using a target transferring structure and a preliminary transferring structure, according to an embodiment;
FIG. 1J schematically illustrates a display device according to an embodiment;
FIG. 1K is a flowchart illustrating a method of transferring a micro semiconductor chip, according to an embodiment;
FIG. 2A illustrates an example in which two preliminary transferring structures are provided, according to an embodiment;
FIG. 2B illustrates an example in which a target transferring structure is provided by using the two preliminary transferring structures illustrated in FIG. 2A;
FIG. 2C is a flowchart illustrating a method of transferring a micro semiconductor chip with reference to FIGS. 2A and 2B;
FIGS. 3A and 3B are views illustrating a base transferring structure used in a method of transferring a micro semiconductor chip, according to embodiments;
FIG. 3C is a flowchart illustrating a method of transferring a micro semiconductor chip with reference to FIGS. 3A and 3B;
FIG. 4 illustrates an example in which micro semiconductor chips are transferred without missing by using a method of transferring a micro semiconductor chip, according to an embodiment;
FIG. 5 illustrates a schematic block diagram of an electronic device according to an embodiment;
FIG. 6 illustrates an example in which a display device is applied to a mobile device, according to an embodiment;
FIG. 7 illustrates an example in which a display device is applied to a display device for a vehicle, according to an embodiment;
FIG. 8 illustrates an example in which a display device is applied to augmented reality glasses, according to an embodiment;
FIG. 9 illustrates an example in which a display device is applied to signage, according to an embodiment; and
FIG. 10 illustrates an example in which a display device is applied to a wearable display, according to an embodiment.

### DETAILED DESCRIPTION

Example embodiments are described in greater detail below with reference to the accompanying drawings.

In the following description, like drawing reference numerals are used for like elements, even in different drawings. The matters defined in the description, such as detailed construction and elements, are provided to assist in a comprehensive understanding of the example embodiments. However, it is apparent that the example embodiments can be practiced without those specifically defined matters. Also, well-known functions or constructions are not described in detail since they would obscure the description with unnecessary detail.

As used herein, the term "and/or" includes any and all combinations of one or more of the associated listed items. Expressions such as "at least one of," when preceding a list of elements, modify the entire list of elements and do not modify the individual elements of the list.

Hereinafter, a method of transferring a micro semiconductor chip and a transferring structure, according to various embodiments, will be described in detail with reference to the accompanying drawings. In the following drawings, the same reference numerals refer to the same components, and the size of each component in the drawings may be exaggerated for clarity and convenience of description. Although the terms first, second, etc. may be used herein to describe various elements or components, these elements or components should not be limited by these terms. These terms are only used to distinguish one element or component from another element or component.

The singular forms are intended to include the plural forms as well, unless the context clearly indicates otherwise. In addition, when a portion "includes" or "comprises" a component, it means that it may further include other components, rather than excluding other components, unless specifically stated to the contrary. Also, the size or thickness of each component in the drawings may be exaggerated for clarity of description. In addition, when a certain material layer is referred to as being on a substrate or another layer, the material layer may be directly in contact with the substrate or the other layer, or another third layer may intervene therebetween. In addition, in embodiments below, a material constituting each layer is illustrative, and other materials may be used.

Also, terms such as "module", etc. used herein refer to units that process at least one function or operation, and the units may be implemented as hardware or software or as a combination of hardware and software.

Certain executions described in the embodiments are examples, and do not limit the technical scope in any way. For the simplicity of the description, the descriptions of existing electronic components, control systems, software, and other functional aspects of the above systems may be omitted. In addition, connections or connecting units of lines between components shown in the drawings are examples of functional connections and/or physical or circuit connections, and may be represented as alternative or additional various functional connections, physical connections, or circuit connections in real devices.

The use of the term "the" and similar indicative terms may correspond to both singular and plural forms.

Operations constituting a method may be performed in an appropriate order unless there is a clear statement that they should be performed in the order described. In addition, the use of all example terms (e.g., etc.) is simply intended to describe the technical aspects in detail, without limiting the scope of the disclosure.

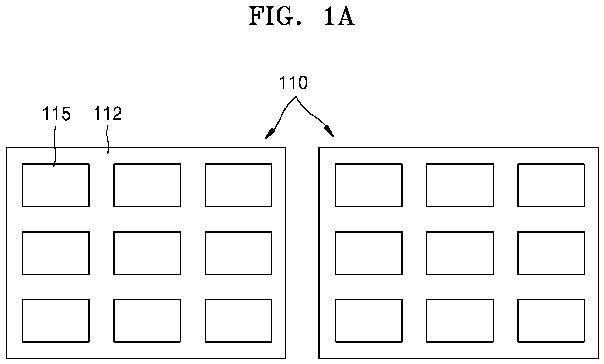

FIG. 1A illustrates a base transferring substrate of a transferring structure, according to an embodiment.

A base transferring substrate 110 may include a transferring mold 112 including a plurality of grooves 115. Each groove 115 may have a size suitable for accommodating a single micro semiconductor chip. N × M grooves 115 may be provided, wherein N and M may be natural numbers in a range of 2 to 1,000. The grooves 115 may be arranged in a N × M matrix structure.

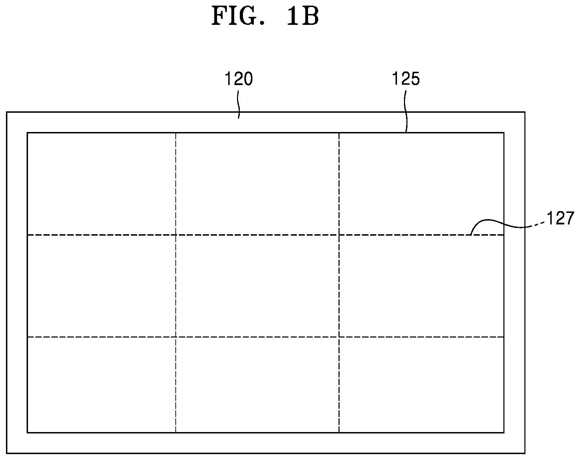

FIG. 1B illustrates a bottom substrate 120 on which the base transferring substrate 110 is arranged. The base transferring substrate 110 is arranged in a region 127 of the bottom substrate 120. An alignment feature such as alignment 125 serving as a reference line or a reference mark, may be provided to ensure that the base transferring substrate 110 may be accurately arranged within the region 127.

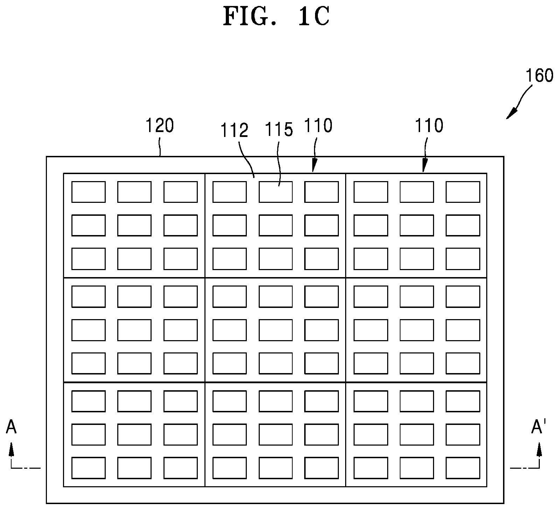

FIG. 1C illustrates a transferring substrate 160 in which a base transferring substrate 110 is assembled to a bottom substrate 120. FIG. 1C illustrates an example in which the base transferring substrate 110 includes 3 × 3 grooves 115, and the base transferring substrate 110 is arranged in a 3 × 3 matrix structure on the bottom substrate 120. The base transferring substrate 110 may be transferred to the bottom substrate 120 in a pick and place method. An adhesive layer may be provided on the bottom substrate 120, and the base transferring substrate 110 may be fixed by the adhesive layer. The adhesive layer may be easily separated by a chemical method or the like.

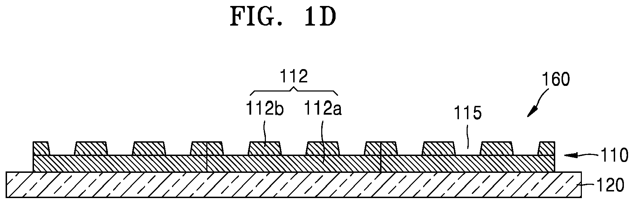

FIGS. 1D to 1G illustrate various examples of a cross-sectional view taken along line A-A' of FIG. 1C.

Referring to FIG. 1D, a plurality of base transferring substrates 110 may be arranged on a bottom substrate 120. A transferring mold 112 of the base transferring substrate 110 may include a substrate 112a and a mold 112b. A groove 115 may be provided in the mold 112b. The bottom substrate 120 may have a flat plate shape.

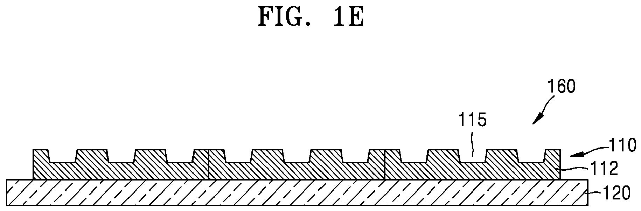

Compared to FIG. 1D, FIG. 1E illustrates an example of a base transferring substrate 110 in which a transferring mold 112 is formed as a single body.

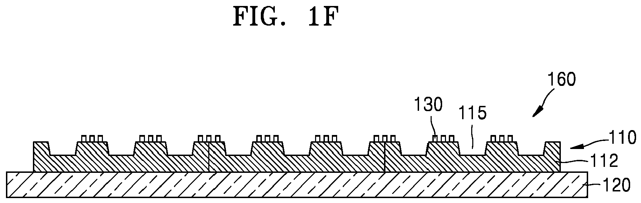

Referring to FIG. 1F, a protrusion pattern 130 may be further provided on an upper surface of the transferring mold 112 of the base transferring substrate 110 illustrated in FIG. 1E. As described below, the protrusion pattern 130 may help easily recover any remaining micro semiconductor chips that might remain after being transferred into the grooves 115.

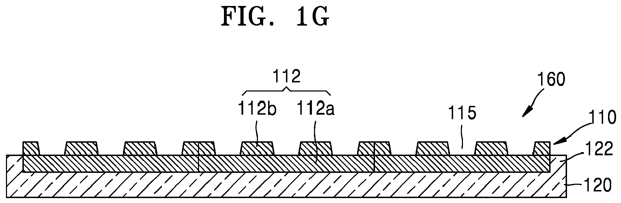

Referring to FIG. 1G, compared to FIG. 1D, a frame 122 for seating a base transferring substrate 110 may be further provided at an edge of a bottom substrate 120. The base transferring substrate 110 may be stably arranged by the frame 122. The frame 122 may be integrally formed with the bottom substrate 120, but may be provided as a separate body.

Micro semiconductor chips may be transferred onto a transferring substrate 160 illustrated in FIG. 1G . Various methods, such as a wet transfer method and a dry transfer method, may be used as a transfer method.

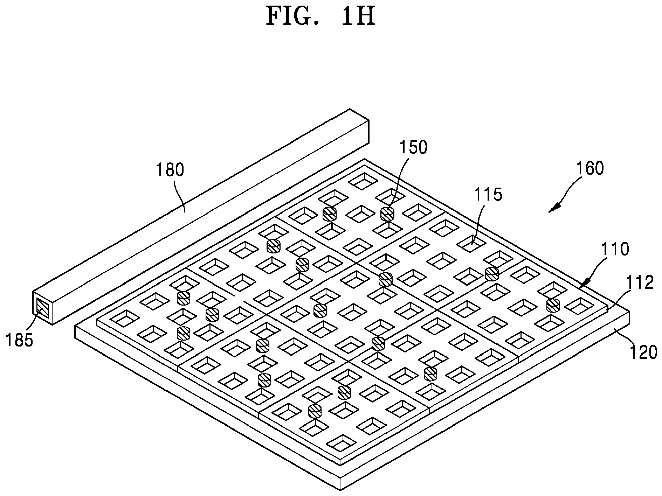

FIG. 1H is a view illustrating an example of a wet transfer method.

A transferring mold 112 of a base transferring substrate 110 may include a plurality of grooves 115, and the grooves 115 may be provided to arrange micro semiconductor chips 150. The micro semiconductor chips 150 may include various types of light emitting devices having a micro size, and the micro size may be 1000 µm or less, or 200 µm or less. The micro semiconductor chip 150 may include, for example, a light emitting diode (LED), complementary metal-oxide semiconductor (CMOS), a CMOS image sensor (CIS), a vertical-cavity surface-emitting laser (VCSEL), a photo diode (PD), a memory device, a two-dimensional (2D) material device, and the like. A 2D material may be graphene, carbon nanotube (CNT), or the like.

Liquid may be supplied to the grooves 115. The liquid may include any type of liquid that does not corrode or damage the semiconductor chips 150. The liquid may include, for example, one or a plurality of combinations of water, ethanol, alcohol, polyol, ketone, halocarbon, acetone, flux, and organic solvent. The organic solvent may include, for example, isopropyl alcohol (IPA). An available liquid is not limited thereto, and various changes may be made.

A method of supplying the liquid to the grooves 115 may include, for example, various methods such as a spray method, a dispensing method, an inkjet dot method, and a method of allowing liquid flowing to the base transferring substrate 110. An amount of liquid supplied may be variously adjusted to fit into the grooves 115 or to overflow from the grooves 115.

A plurality of micro semiconductor chips 150 may be supplied to each base transferring substrate 110. The micro semiconductor chips 150 may be directly sprayed onto the base transferring substrate 110 without any other liquid or may be supplied in a state of being included in a suspension. A method of supplying the micro semiconductor chips 150 included in the suspension may include various methods such as a spray method, a dispensing method of dropping liquid in droplets, an inkjet dot method of ejecting liquid like a printing method, and a method of allowing a suspension to flow onto the base transferring substrate 110.

The base transferring substrates 110 may be equipped or assembled with an absorbent material 180 capable of absorbing liquid. The absorbent material 180 may scan the base transferring substrates 110. The absorbent material 180 may be any material capable of absorbing liquid, and a shape or structure thereof is not limited. The absorbent material 180 may include, for example, fabric, tissue, polyester fiber, paper, or wiper. The absorbent material 180 may be used alone without other auxiliary devices, but is not limited thereto, and may be coupled or affixed to a support 185 to conveniently scan the base transferring substrate 110. The support 185 may have various shapes and structures appropriate for scanning the base transferring substrate 110. For example, the support 185 may have the shape of, for example, a rod, a blade, a plate, or a wiper. The absorbent material 180 may be provided on any one surface of the support 185, or may surround a circumference of the support 185.

The absorbent material 180 may scan the base transferring substrate 110 while applying appropriate pressure onto the base transferring substrate 110. Scanning may include an operation of the absorbent material 180 absorbing any liquid present on the base transferring substrate 110 while contacting the base transferring substrate 110 and moving across the plurality of grooves 115. Scanning may be performed in various methods, such as a sliding method, a rotating method, a translating method, a reciprocating method, a rolling method, a spinning method, and/or a rubbing method of the absorbent material 180, and may include both a regular method and an irregular method. Scanning may also be performed by moving the transferring substrate 160 with which the base transferring substrate 110 is assembled, instead of moving the absorbent material 180, and scanning of the transferring substrate 160 may also be performed in a method such as sliding, rotating, translating, reciprocating, rolling, spinning, or rubbing. Scanning may also be performed by cooperation between the absorbent material 180 and the transferring substrate 160.

The wet transfer method has been described above as a method of transferring the micro semiconductor chip 150, but the micro semiconductor chip 150 may also be transferred to the transferring substrate 160 by using a dry transfer method or a pick and place transfer method.

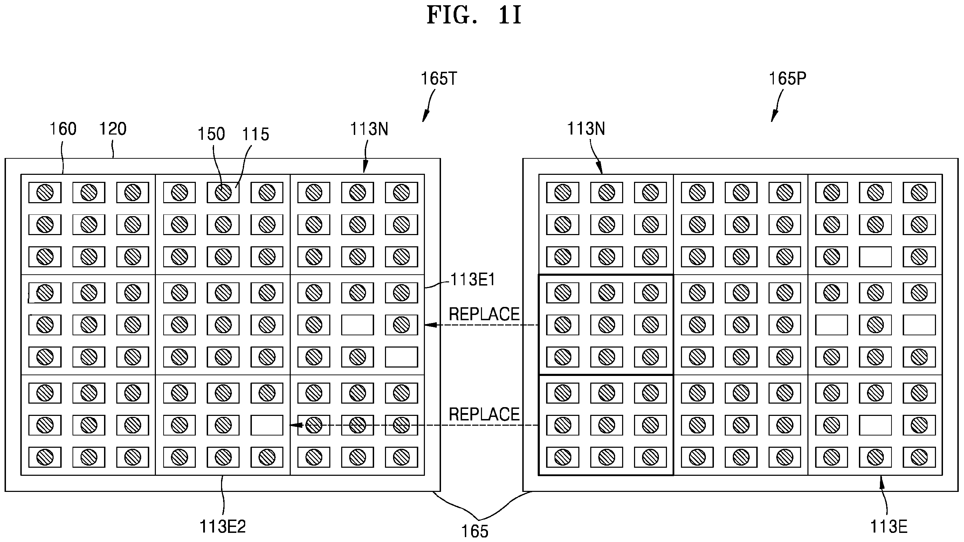

FIG. 1I illustrates two transferring structures to which micro semiconductor chips are transferred according to a method described above. A transferring structure 165 refers to a structure in which micro semiconductor chips 150 are transferred to grooves 115 of a transferring substrate 160.

The transferring structure 165 may include a target transferring structure 165T and a preliminary transferring structure 165P. The target transferring structure 165T may refer to a target wafer (e.g., a display substrate) that receives the micro semiconductor chips 150 from a source wafer, and the preliminary transferring structure 165P may refer to a structure or a means to supply a normal base transferring structure 113N to the target transferring structure 165T when there are missing micro semiconductor chips in the target transfer structure 165T .

When the micro semiconductor chips 150 are transferred to the target transferring structure 165T and the preliminary transferring structure 165P, a case in which some of the micro semiconductor chips 150 are missing may occur. As used herein, a structure in which all micro semiconductor chips 150 are transferred to the base transferring substrate 110 without missing may be referred to as the normal base transferring structure 113N, and a structure in which at least one micro semiconductor chip 150 is missing may be referred to as an error base transferring structure 113E. After transferring the micro semiconductor chips 150, the error base transferring structure 113E may be detected by inspecting whether the micro semiconductor chips 150 are missing.

A first error base transferring structure 113E1 and a second error base transferring structure 113E2 may be generated in the target transferring structure 165T. In this case, only the normal base transferring structure 113N without an error may be provided to the entire target transferring structure 165T by replacing the first error base transferring structure 113E1 and the second error base transferring structure 113E2 with the normal base transferring structure 113N of the preliminary transferring structure 165P.

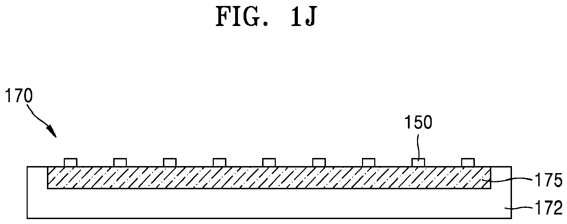

FIG. 1J illustrates that a display device 170 is manufactured by using the target transferring structure 165T shown in FIG. 1I. Referring to FIG. 1J, the display device 170 may include a display substrate 172 including a driving circuit 175, and micro semiconductor chips 150 bonded to the display substrate 172. The display substrate 172 may be a backplane substrate. The micro semiconductor chips 150 may be transferred from the target transferring structure 165T to the display substrate 172 and bonded thereto. The target transferring structure 165T may be transferred as a whole without missing the micro semiconductor chips 150, and thus, the micro semiconductor chips 150 may be bonded to respective pixels of the display substrate 172 without any empty space and electrically connected to the driving circuit 175.

The driving circuit 175 may include thin film transistors (TFTs). According to a semiconductor material of the transistors, the transistors may be classified into amorphous silicon, polysilicon, single crystal silicon, and oxide transistors, and an image may be displayed by adjusting light emission on/off and light emission intensity through a combination of transistors in each sub-pixel. In the display device 170, a micro light emitting device may be driven for each sub-pixel by TFT-based current supply, and various form factors may be implemented on the basis of stability of the micro light emitting device, which is an inorganic material, and may be resistant to deterioration.

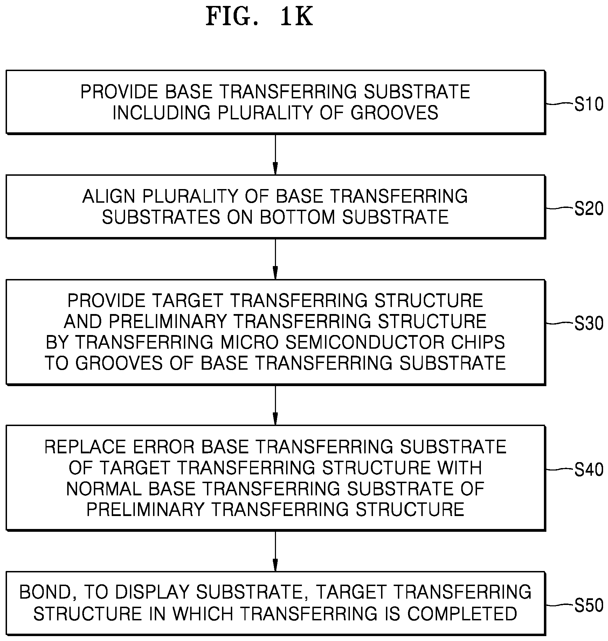

FIG. 1K is a flowchart illustrating a method of transferring a micro semiconductor chip, according to an embodiment.

Referring to FIGS. 1K and 1A, in operation S10, the base transferring substrate 110 including a plurality of grooves 115 may be provided. In addition, referring to FIGS. 1K and 1C, in operation S20, the transferring substrate 160 may be assembled by aligning a plurality of base transferring substrates 110 on the bottom substrate 120. Referring to FIGS. 1K and 1I, in operation S30, the target transferring structure 165T and the preliminary transferring structure 165P may be provided by transferring the micro semiconductor chips 150 to the transferring substrate 160. In addition, in operation S40, the error base transferring structure 113E in which the micro semiconductor chips 150 are missing without being transferred, from among the base transferring structures 113 of the target transferring structure 165T, may be replaced with the normal base transferring structure 113N from among the base transferring structures 113 of the preliminary transferring structure 165P. Accordingly, a yield of 100 % may be achieved without the error base transferring structure 113E in the target transferring structure 165T. In addition, in operation S50, target transferring structure 165T in which transferring is completed is bonded to the display substrate.

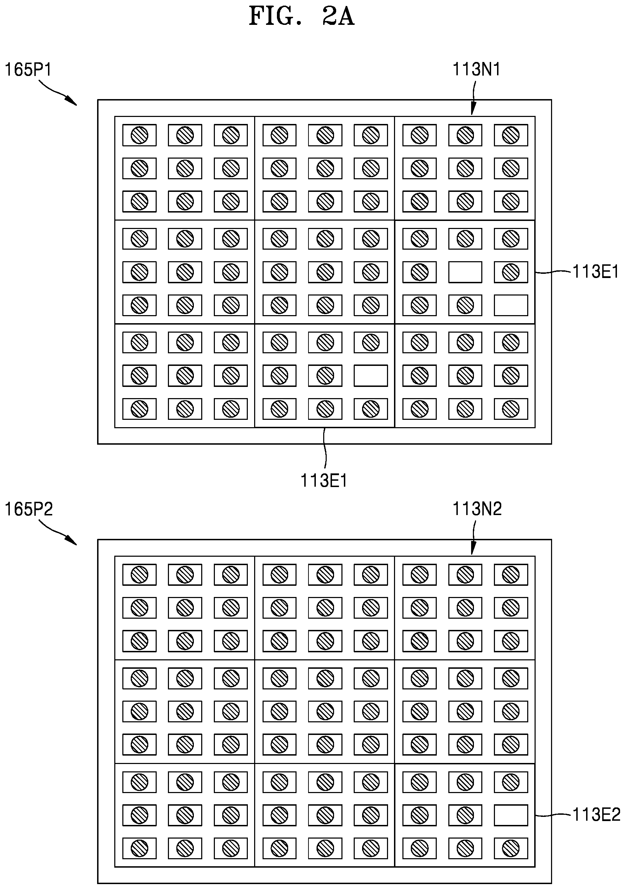

FIG. 2A illustrates that two preliminary transferring structures are provided.

A first preliminary transferring structure 165P1 may include a first normal base transferring structure 113N1 and a first error base transferring structure 113E1, and a second preliminary transferring structure 165P2 may include a second normal base transferring structure 113N2 and a second error base transferring structure 113E2. A target transferring structure may be assembled by using the first preliminary transferring structure 165P1 and the second preliminary transferring structure 165P2.

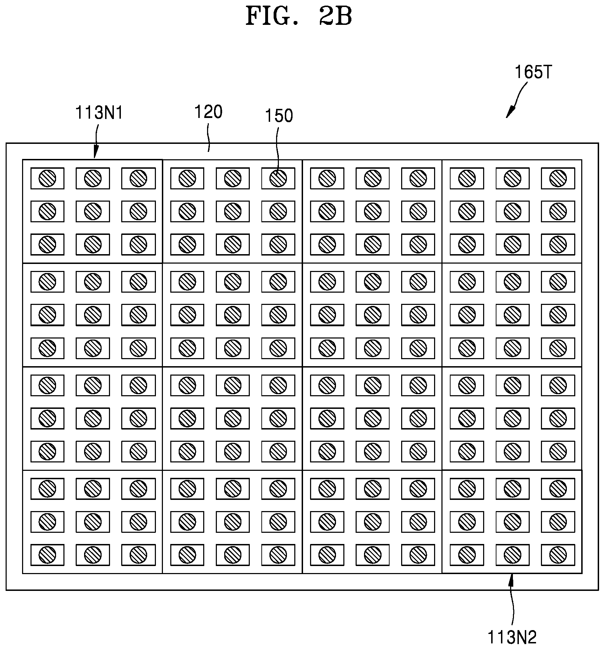

Referring to FIG. 2B, a target transferring structure 165T may be assembled by aligning the first normal base transferring structure 113N1 of the first preliminary transferring structure 165P1 and the second normal base transferring structure 113N2 of the second preliminary transferring structure 165P2 on a bottom substrate 120. Only a normal base transferring structure may be transferred to the bottom substrate 120, and thus, the target transferring structure 165T may be completed without missing the micro semiconductor chips 150.

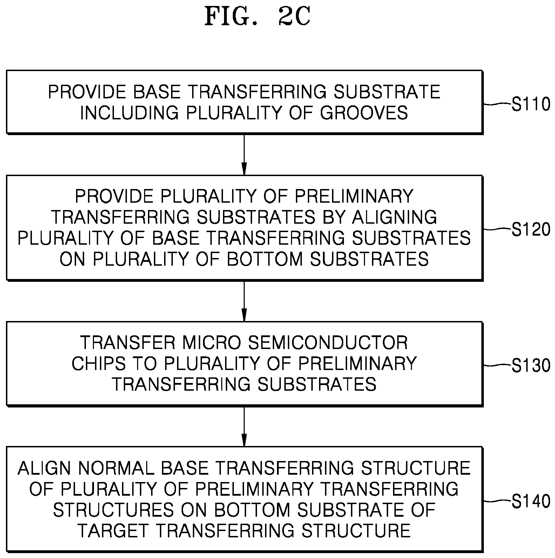

FIG. 2C is a flowchart illustrating a method of transferring a micro semiconductor chip described with reference to FIGS. 2A and 2B.

Referring to FIG. 2C, in operation S110, the base transferring substrate 110 including a plurality of grooves 115 may be provided. Referring back to FIG. 1C, in operation S120, a plurality of preliminary transferring substrates may be provided by aligning a plurality of base transferring substrates 110 on a plurality of bottom substrates 120. In operation S130, a preliminary transferring structure may be provided by transferring micro semiconductor chips 150 to the plurality of preliminary transferring substrates. An inspection may be made to identify whether or not the base transferring structures 113 of the preliminary transferring structures 165P1 and 165P2 include the base transferring structure 113 in which the micro semiconductor chips 150 are missing. In operation S140, from among the base transferring substrates 110 of a plurality of preliminary transferring structures 165P1 and 165P2, the normal base transferring structures 113N1 and 113N2 to which the micro semiconductor chips 150 are transferred may be selected and aligned on the bottom substrate 120 of the target transferring structure 165T. Accordingly, the target transferring structure 165T may increase a transfer yield of the micro semiconductor chips 150.

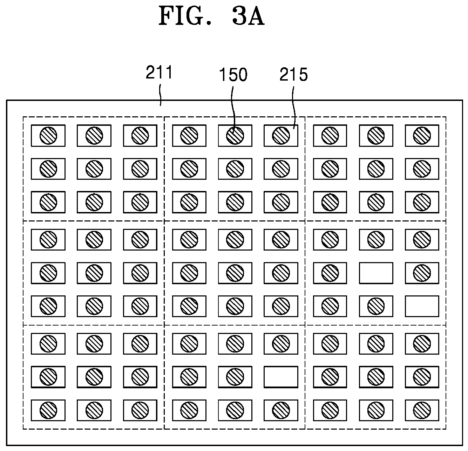

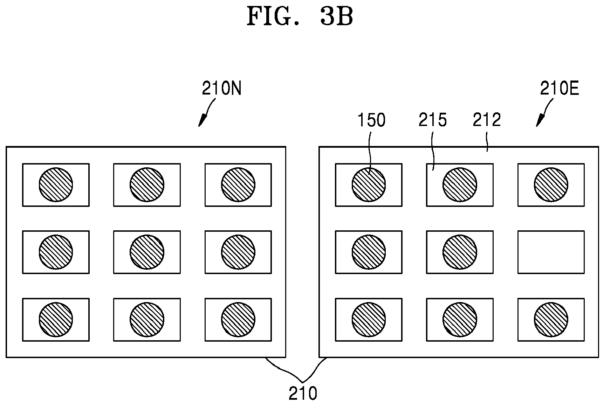

FIGS. 3A and 3B are views illustrating a method of transferring micro semiconductor chips, according to some embodiments.

Micro semiconductor chips 150 may be transferred to a transferring mold substrate 211 including a plurality of grooves 215. A wet transfer method or a dry transfer method may be used as a method of transferring the micro semiconductor chips 150. A base transferring structure 210 may be formed as shown in FIG. 3B by dicing or segmenting the transferring mold substrate 211 along the dashed lines depicted in FIG. 3A, resulting in a plurality of transferring mold substrates 211. The base transferring structure 210 may include N × M grooves 215, and N and M may be natural numbers in a range of 2 to 1000. FIG. 3B illustrates an example in which the base transferring structure 210 includes 3 × 3 grooves 215. The base transferring structure 210 may include a transferring mold 212, the grooves 215 provided in the transferring mold 212, and the micro semiconductor chips 150 provided in the grooves 215. The base transferring structure 210 may include a normal base transferring structure 210N in which the micro semiconductor chips 150 are transferred to all the grooves 215 without missing and an error base transferring structure 210E in which some of the micro semiconductor chips 150 are missing.

A target transferring structure may be completed without missing the micro semiconductor chips 150 by selecting only the normal base transferring structure 210N to which the micro semiconductor chips 150 are transferred and aligning the selected normal base transferring structure 210N on a bottom substrate (120 in FIG. 1C). In the present embodiment, the target transferring structure may be assembled by using only the normal base transferring structure 210N to which the micro semiconductor chips 150 are transferred.

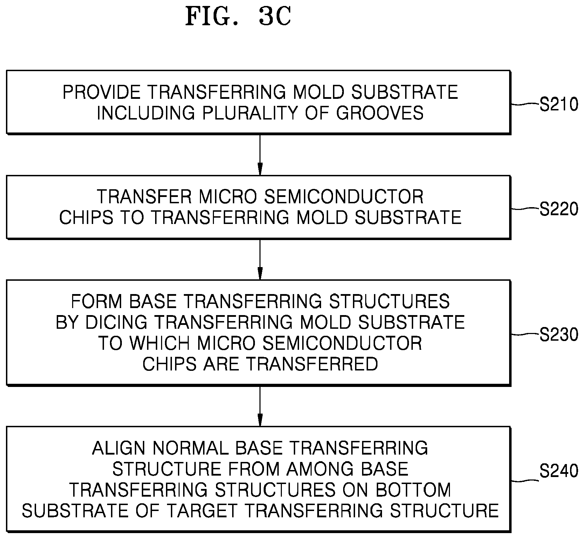

FIG. 3C is a flowchart illustrating a method of transferring micro semiconductor chips described with reference to FIGS. 3A and 3B.

Referring to FIG. 3C, in operation S210, the transferring mold substrate 211 including a plurality of grooves 215 may be provided. In operation S220, micro semiconductor chips 150 may be transferred to the grooves 215 of the transferring mold substrate 211. Micro semiconductor chips 150 may be transferred to most of the grooves 215, but there might be some grooves 215 where micro semiconductor chips 150 are absent. In operation S230, the base transferring structure 210 may be formed by segmenting or dicing the transferring mold substrate 211. The normal base transferring structure 210N and the error base transferring structure 210E may be detected by inspecting the base transferring structure 210. In operation S240, the normal base transferring structure 210N may be selected from among the base transferring structures 210 and aligned on a bottom substrate of the target transferring structure. As a result, a transfer yield of the micro semiconductor chips 150 with respect to the target transferring structure may be increased.

As described above, the method of transferring a micro semiconductor chip, according to an embodiment, may increase the transfer yield by easily replacing a portion in which a micro semiconductor chip is missing by using the base transferring substrate.

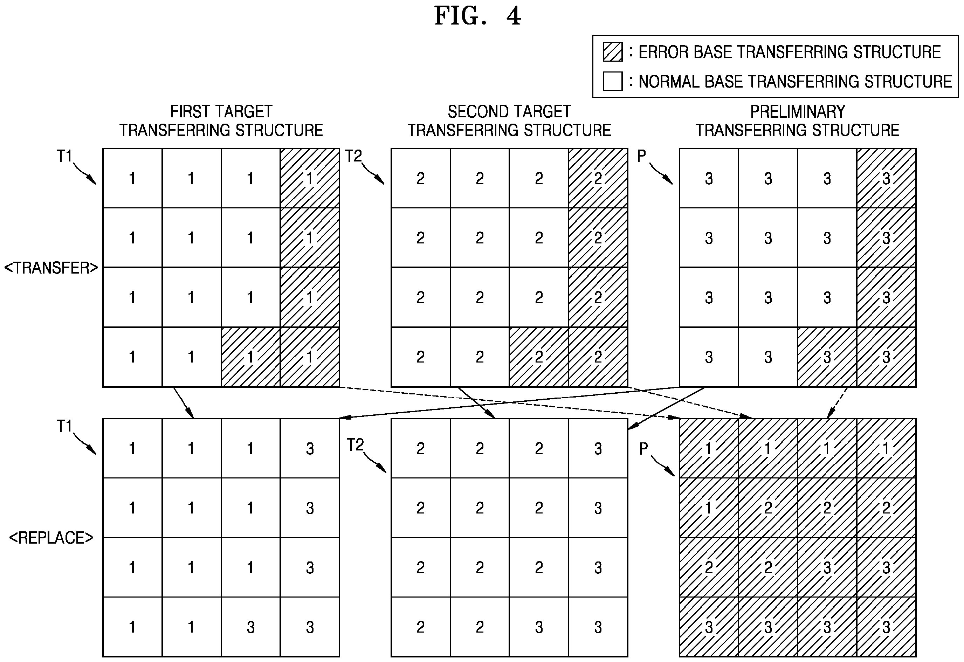

FIG. 4 illustrates an example of transferring a micro semiconductor chip to a target transferring structure by using a method of transferring a micro semiconductor chip, according to an embodiment.

A base transferring substrate may be aligned on a bottom substrate of a first target transferring structure T1, and micro semiconductor chips may be transferred thereto. A base transferring structure of the first target transferring structure T1 may be indicated by number 1. A base transferring substrate may be aligned in a second target transferring structure T2, and micro semiconductor chips may be transferred thereto. A base transferring structure of the second target transferring structure T2 may be indicated by number 2. A base transferring substrate may be aligned in a preliminary transferring structure P, and micro semiconductor chips may be transferred thereto. A base transferring structure of the preliminary transferring structure P may be indicated by number 3. In FIG. 4, a portion without slashes may indicate a normal base transferring structure, and a portion with slashes may indicate an error base transferring structure.

A micro semiconductor chip transfer yield of the first target transferring structure T1 and the second target transferring structure T2 may achieve up to 100 % by replacing the error base transferring structures of the first target transferring structure T1 and the second target transferring structure T2 with normal base transferring structures of the preliminary transferring structure P. In addition, the error base transferring structures, which are transferred from the first target transferring structure T1 and the second target transferring structure T2 to the preliminary transferring structure P, may be recycled. In other words, micro semiconductor chips may be re-transferred to the error base transferring structure to make the error base transferring structure into a normal base transferring structure, and then the normal base transferring structure may be replaced with an error base transferring structure of another target transferring structure.

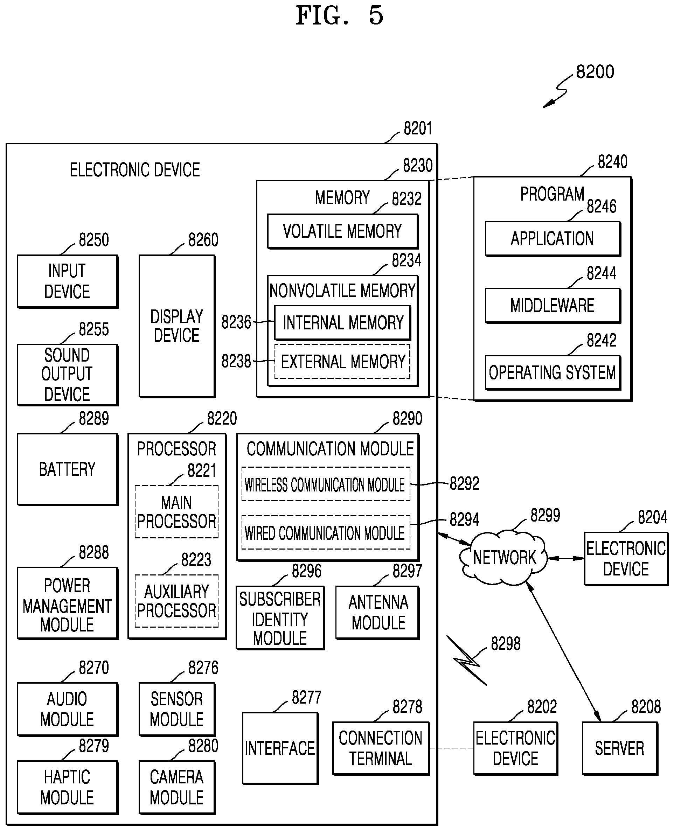

FIG. 5 illustrates a block diagram of an electronic device including a display device, according to an embodiment.

Referring to FIG. 5, an electronic device 8201 may be provided in a network environment 8200. In the network environment 8200, the electronic device 8201 may communicate with another electronic device 8202 through a first network 8298 (e.g., a short-range wireless communication network or the like), or may communicate with another electronic device 8204 and/or a server 8208 through a second network 8299 (e.g., a long-range wireless communication network or the like). The electronic device 8201 may communicate with the electronic device 8204 through the server 8208. The electronic device 8201 may include a processor 8220, a memory 8230, an input device 8250, a sound output device 8255, a display device 8260, an audio module 8270, a sensor module 8276, an interface 8277, a haptic module 8279, a camera module 8280, a power management module 8288, a battery 8289, a communication module 8290, a subscriber identity module 8296, and/or an antenna module 8297. Some of the components may be omitted from or other components may be added to the electronic device 8201. Some of the components may be implemented as a single integrated circuit. For example, the sensor module (8276) (e.g., a fingerprint sensor, an iris sensor, an illuminance sensor, or the like) may be implemented by being embedded in the display device 8260 (e.g., a display or the like).

The processor 8220 may control one or a plurality of other components (e.g., hardware, software components, and the like) of the electronic device 8201 connected to the processor 8220 and may perform various types of data processing or operations, by executing software (e.g., a program 8240 or the like). As a portion of the data processing or operations, the processor 8220 may load a command and/or data received from another component (e.g., the sensor module 8276, the communication module 8290, or the like) into a volatile memory 8232, process a command and/or data stored in the volatile memory 8232, and store result data in a nonvolatile memory 8234. The nonvolatile memory 8234 may include an internal memory 8236 and an external memory 8238. The processor 8220 may include a main processor 8221 (e.g., a central processing unit, an application processor, or the like) and an auxiliary processor 8223 (e.g., a graphic processing unit, an image signal processor, a sensor hub processor, a communication processor, or the like) that may be operated independently thereof or together therewith. The auxiliary processor 8223 may use less power than the main processor 8221 and perform a particularized function.

The auxiliary processor 8223 may control functions and/or states related to some of the components (e.g., the display device 8260, the sensor module 8276, the communication module 8290, and the like) of the electronic device 8201, on behalf of the main processor 8221 while the main processor 8221 is in an inactive state (a sleep state) or together with the main processor 8221 while the main processor 8221 is in an active state (an application execution state). The auxiliary processor 8223 (e.g., the image signal processor, the communication processor, or the like) may be implemented as a portion of another functionally related component (e.g., the camera module 8280, the communication module 8290, or the like).

The memory 8230 may store various types of data needed by the components (e.g., the processor 8220, the sensor module 8276, and the like) of the electronic device 8201. The data may include, for example, software (e.g., the program 8240 or the like), and input data and/or output data for a command related thereto. The memory 8230 may include the volatile memory 8232 and/or the nonvolatile memory 8234.

The program 8240 may be stored as software in the memory 8230, and may include an operating system 8242, middleware 8244, and/or an application 8246.

The input device 8250 may receive, from the outside (e.g., a user or the like) of the electronic device 8201, commands and/or data to be used for the components (e.g., the processor 8220 and the like) of the electronic device 8201. The input device 8250 may include a remote controller, a microphone, a mouse, a keyboard, and/or a digital pen (e.g., a stylus pen or the like).

The sound output device 8255 may output a sound signal to the outside of the electronic device 8201. The sound output device 8255 may include a speaker and/or a receiver. The speaker may be used for a general purpose, such as multimedia playback or recording playback, and the receiver may be used to receive an incoming call. The receiver may be coupled to the speaker as a portion thereof or may be implemented as a separate device independent thereof.

The display device 8260 may visually provide information to the outside of the electronic device 8201. The display device 8260 may include a display, a hologram device, or a projector, and a control circuit for controlling the corresponding device. The display device 8260 may include a display device according to an embodiment. The display device 8260 may include touch circuitry configured to detect a touch, and/or sensor circuitry (e.g., a pressure sensor, or the like) configured to measure an intensity of a force generated by the touch.

The audio module 8270 may convert a sound into an electrical signal, or conversely, convert an electrical signal into a sound. The audio module 8270 may acquire a sound through the input device 8250, or output a sound through the sound output device 8255, and/or a speaker and/or headphones of another electronic device (e.g., the electronic device 8202 or the like) directly or wirelessly connected to the electronic device 8201.

The sensor module 8276 may detect an operating state (e.g., power, temperature, or the like) of the electronic device 8201 or an external environmental state (e.g., a user state or the like) and generate an electrical signal and/or a data value corresponding to the detected state. The sensor module 8276 may include a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The interface 8277 may support one or more predefined protocols that may be used for the electronic device 8201 to directly or wirelessly connect to another electronic device (e.g., the electronic device 8202 or the like). The interface 8277 may include a high definition multimedia interface (HDMI), a universal serial bus (USB) interface, an SD card interface, and/or an audio interface.

A connection terminal 8278 may include a connector through which the electronic device 8201 may be physically connected to another electronic device (e.g., the electronic device 8202 or the like). The connection terminal 8278 may include an HDMI connector, a USB connector, an SD card connector, and/or an audio connector (e.g., a headphone connector or the like).

The haptic module 8279 may convert an electrical signal into a mechanical stimulus (e.g., vibration, movement, or the like) or an electrical stimuli that may be perceived by the user through a tactile or kinesthetic sense. The haptic module 8279 may include a motor, a piezoelectric element, and/or an electrical stimulation device.

The camera module 8280 may capture a still image and a moving image. The camera module 8280 may include a lens assembly including one or more lenses, image sensors, image signal processors, and/or flashes. The lens assembly included in the camera module 8280 may collect light emitted from a subject which is a target of image capturing.

The power management module 8288 may manage power supplied to the electronic device 8201. The power management module 8288 may be implemented as portion of a power management integrated circuit (PMIC).

The battery 8289 may supply power to components of the electronic device 8201. The battery 8289 may include a non-rechargeable primary battery, a rechargeable secondary battery, and/or a fuel cell.

The communication module 8290 may support establishment of a direct (wired) communication channel and/or wireless communication channel between the electronic device 8201 and another electronic device (e.g., the electronic device 8202, the electronic device 8204, the server 8208, or the like), and communication performance through the established communication channels. The communication module 8290 may include one or more communication processors that are operated independently of the processor 8220 (e.g., the application processor or the like) and support direct communication and/or wireless communication. The communication module 8290 may include a wireless communication module 8292 (e.g., a cellular communication module, a short-range wireless communication module, or a global navigation satellite system (GNSS) communication module) and/or a wired communication module 8294 (e.g., a local area network (LAN) communication module, a power line communication module, or the like). From among the communication modules, a corresponding communication module may communicate with another electronic device through the first network 8298 (e.g., a short-range communication network such as Bluetooth, WiFi Direct, or Infrared Data Association (IrDA)) or the second network 8299 (e.g., a long-range communication network such as a cellular network, the Internet, or a computer network (e.g., a LAN, a WAN, or the like)). Various types of communication modules as described above may be integrated into one component (e.g., a single chip), or may be implemented as a plurality of components (e.g., a plurality of chips) separate from each other. The wireless communication module 8292 may verify and authenticate the electronic device 8201 within a communication network such as the first network 8298 and/or the second network 8299 by using subscriber information (e.g., the International Mobile Subscriber Identity (IMSI)) stored in the subscriber identity module 8296.

The antenna module 8297 may transmit or receive a signal and/or power to or from the outside (e.g., another electronic device or the like). An antenna may include a radiator including a conductive pattern formed on a substrate (e.g., a PCB or the like). The antenna module 8297 may include one or a plurality of antennas. When the plurality of antennas are included, an antenna, which is appropriate for a communication scheme used in a communication network such as the first network 8298 and/or the second network 8299, may be selected by the communication module 8290 from among the plurality of antennas. A signal and/or power may be transmitted or received between the communication module 8290 and another electronic device through the selected antenna. Another component (e.g., a radio frequency integrated circuit (RFIC) or the like) may be included as a portion of the antenna module 8297, in addition to the antenna.

Some of the components may be connected to each other and exchange a signal (e.g., a command, data, or the like) through a communication scheme (e.g., a bus, general purpose input and output (GPIO), a serial peripheral interface (SPI), a mobile industry processor interface (MIPI), or the like) between peripheral devices.

The command or data may be transmitted or received between the electronic device 8201 and the external electronic device 8204 through the server 8208 connected to the second network 8299. The other electronic devices 8202 and 8204 may be the same or different types of devices as or from the electronic device 8201. All or some of operations executed on the electronic device 8201 may be executed on one or more of the other electronic devices 8202, 8204, and 8208. For example, when the electronic device 8201 needs to perform a certain function or service, the electronic device 8201 may request one or more other electronic devices to perform a portion or all of the function or service, instead of autonomously executing the function or service. One or more other electronic devices, which receive the request, may execute an additional function or service related to the request and transmit the result of the execution to electronic device 8201. To this end, cloud computing, distributed computing, and/or client-server computing technology may be used.

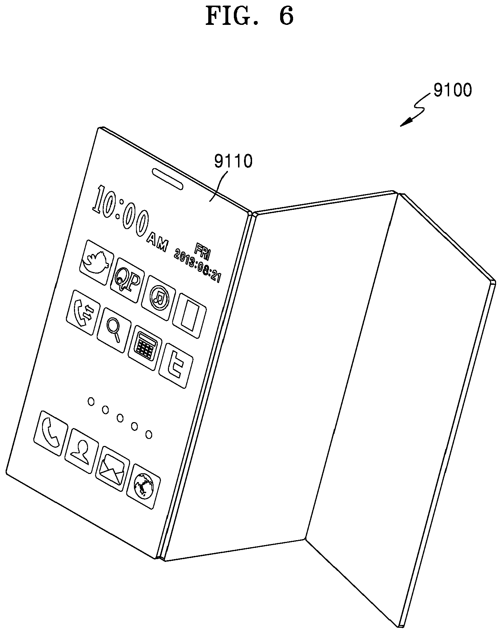

FIG. 6 illustrates an example in which an electronic device is applied to a mobile device, according to an embodiment. A mobile device 9100 may include a display device 9110 and the display device 9110 may include display devices according to an embodiment. The display device 9110 may have a foldable structure, for example, a multi-foldable structure.

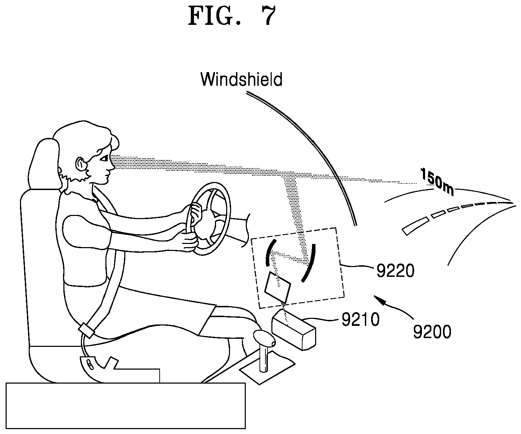

FIG. 7 illustrates an example in which a display device is applied to a vehicle, according to an embodiment. The display device may be a head-up display device 9200 for a vehicle, and may include a display 9210 provided in one region of the vehicle, and an optical path change unit 9220 that converts an optical path so that a driver may see an image generated on the display 9210.

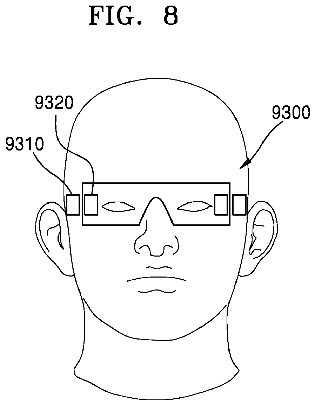

FIG. 8 illustrates an example in which a display device is applied to augmented reality glasses or virtual reality glasses, according to an embodiment. Augmented reality glasses 9300 may include a projection system 9310 that forms an image and an element 9320 that guides the image from the projection system 9310 to enter eyes of a user. The projection system 9310 may include a display device according to an embodiment.

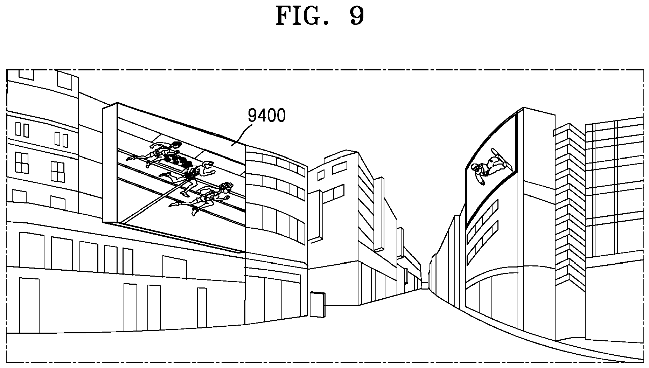

FIG. 9 illustrates an example in which a display device is applied to large signage, according to an embodiment. Signage 9400 may be used for an outdoor advertisement using a digital information display, and may control advertisement content through a communication network. For example, the signage 9400 may be implemented through an electronic device described above with reference to FIG. 5.

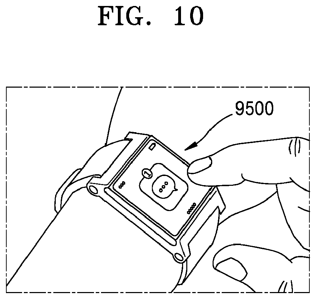

FIG. 10 illustrates an example in which a display device is applied to a wearable display, according to an embodiment. A wearable display 9500 may include a display device according to an embodiment, and may be implemented through the electronic device described above with reference to FIG. 5.

The display device according to an embodiment may be applied to various types of products such as a rollable TV and a stretchable display.

A method of transferring a micro semiconductor chip, according to an embodiment, may increase a transfer yield of the micro semiconductor chip by using a base transferring substrate. A transferring structure according to an embodiment may include a base transferring substrate to easily replace a portion in which a micro semiconductor chip is missing.

The foregoing exemplary embodiments are merely exemplary and are not to be construed as limiting. The present teaching can be readily applied to other types of apparatuses. Also, the description of the exemplary embodiments is intended to be illustrative, and not to limit the scope of the claims, and many alternatives, modifications, and variations will be apparent to those skilled in the art.

## Claims

1. A method of transferring a micro semiconductor chip, the method comprising:
providing a plurality of base transferring substrates each including a plurality of grooves;
aligning the plurality of base transferring substrates on a first bottom substrate;
aligning the plurality of base transferring substrates on a second bottom substrate;
providing a target transferring structure by transferring micro semiconductor chips to the base transferring substrates of the first bottom substrate;
providing a preliminary transferring structure by transferring micro semiconductor chips to the base transferring substrates of the second bottom substrate; and
replacing an error base transferring structure which micro semiconductor chips are not transferred, from among base transferring structures of the target transferring structure, with a normal base transferring structure on which micro semiconductor chips are transferred, from among base transferring structures of the preliminary target transferring structure.

2. A method of transferring a micro semiconductor chip, the method comprising:
providing a plurality of base transferring substrates comprising a plurality of grooves;
providing a plurality of preliminary transferring substrates by aligning the plurality of base transferring substrates on a plurality of bottom substrates;
forming a preliminary transferring structure by transferring micro semiconductor chips to the plurality of preliminary transferring substrates; and
aligning, on a bottom substrate of a target transferring structure, a normal base transferring structure to which micro semiconductor chips are transferred, from among base transferring structures of the plurality of preliminary transferring substrates.

3. A method of transferring a micro semiconductor chip, the method comprising:
providing a transferring mold substrate comprising a plurality of grooves;
transferring micro semiconductor chips to the transferring mold substrate;
forming base transferring structures by segmenting the transferring mold substrate to which the micro semiconductor chips are transferred; and
aligning, on a bottom substrate of a target transferring structure, a normal base transferring structure to which the micro semiconductor chips are transferred, from among the base transferring structures.

4. The method of any preceding claim, wherein the transferring of the micro semiconductor chips are performed by a wet transfer method or a dry transfer method.

5. The method of any preceding claim, wherein the base transferring substrate includes a substrate and a mold provided on the substrate, and the grooves are provided in the mold.

6. The method of any preceding claim, wherein the base transferring substrate includes a transferring mold, and a protrusion pattern is provided on an upper surface of the transferring mold.

7. The method of claim 1, 2, 4, 5 or 6, wherein each of the plurality of base transferring substrates comprises N × M grooves, wherein N and M are natural numbers in a range of 2 to 1,000.

8. The method of claim 1, 2, 4, 5, 6 or 7, further comprising bonding the micro semiconductor chips, which are transferred to the plurality of base transferring substrates of the target transferring structure, to a display substrate.
